# EUROPEAN PATENT SPECIFICATION

(11) **EP 2 447 293 B1**
(45) Date of publication and mention of the grant of the patent: **04.06.2014**
(21) Application number: 09846551.1
(22) Date of filing: 19.11.2009
(51) Int. Cl.: C08F 283/01, H02K 3/30, H02K 5/08, C08F 299/04, C08K 5/14, C08K 3/00

(54) **UNSATURATED POLYESTER RESIN COMPOSITION AND ENCAPSULATED MOTOR**
UNGESÄTTIGTE POLYESTERHARZZUSAMMENSETZUNG UND VERKAPSELTER MOTOR
COMPOSITION DE RÉSINE POLYESTER INSATURÉ ET MOTEUR ENCAPSULÉ

(30) Priority: 24.06.2009 JP 2009149792
(43) Date of publication of application: 02.05.2012
(73) Proprietor: Showa Denko K.K., Tokyo 105-8518 (JP); TOYOTA JIDOSHA KABUSHIKI KAISHA, Toyota-shi, Aichi-ken, 471-8571 (JP)
(72) Inventor: ISHIUCHI, Ryujin, Tatsuno-shi Hyogo 679-4155 (JP); TAMURA, Akifumi, Tatsuno-shi Hyogo 679-4155 (JP); KANEOKA, Hidekazu, Tatsuno-shi Hyogo 679-4155 (JP); SUGITA, Hiroaki, Toyota-shi Aichi 471-8571 (JP)
(74) Representative: Regimbeau
(86) International application number: PCT/JP2009/069630
(87) International publication number: WO 2010/150423

(56) References cited:
- JP-A- 2001 226 573
- JP-A- 2007 146 125
- JP-A- 2009 073 975
- JP-A- 2009 077 576
- JP-A- 2009 077 577

## Description

### Technical Field

The present invention relates to an unsaturated polyester resin composition and an encapsulated motor to be used in OA equipment, the field of parts for general industrial machinery, the field of automobiles, the field of heavy electric machinery, and the like. More specifically, the present invention relates to an unsaturated polyester resin composition to be used for encapsulating electrical and electronic parts such as a motor and a coil, and an encapsulated motor, which is obtained by using the unsaturated polyester resin composition.

### Background Art

An unsaturated polyester resin composition, in particular, a bulk molding compound (BMC) yields a cured product excellent in dimensional accuracy, mechanical characteristics, and flowability, and hence is widely used as an encapsulating material for motors, power generators, and the like to be used in various fields.

Further, regarding a product such as a motor involving a problem of performance degradation due to heat generation, there is also known a method involving the use of an epoxy resin composition including an inorganic filler having a high thermal conductivity coefficient as an encapsulating material from the viewpoint of improving heat dissipation properties (see, for example, Patent Documents 1 and 2). However, the amount of inorganic filler that can be blended in an epoxy resin composition is smaller than that in an unsaturated polyester resin composition. Therefore, for example, epoxy resin compositions involve problems in that they provide insufficient thermal conductivity coefficients, requires after-cure, and yields a cured product having a high molding shrinkage ratio, which is easily cracked. As described above, epoxy resin compositions involve a number of problems in terms of moldability, workability, physical properties of a cured product, and the like as compared to unsaturated polyester resin compositions.

On the other hand, unsaturated polyester resin compositions may be easily kneaded and manufactured with high-load manufacturing equipment, and hence may be blended with large amounts of an inorganic filler having high thermal conductivity coefficients as compared to epoxy resin compositions. Further, unsaturated polyester resin compositions can be subjected to closed molding using a molding machine (for example, an injection molding machine or a transfer molding machine) and a mold, and also have an advantage of not requiring any post-processing such as after-cure.

Patent Document 3 discloses, as an example of an unsaturated polyester resin composition which may be used as the encapsulating material, one including an unsaturated polyester resin, an inorganic filler, glass fiber, and a low profile additive.

### Citation List

### Patent Documents

Patent Document 1: JP 2005-330390 A
Patent Document 2: JP 2008-222824 A
Patent Document 3: JP 2001-226573 A

### Disclosure of the Invention

### Problems to be Solved by the Invention

However, although the unsaturated polyester resin composition of Patent Literature 3 can yield a cured product, which is excellent in in-mold flowability and has a low molding shrinkage ratio, a low linear expansion coefficient, and a high thermal conductivity coefficient, the unsaturated polyester resin composition involves a problem in terms of low productivity of a cured product (for example, an encapsulated product) due to its low curing speed.

Further, although it is conceivable that only a curing agent for increasing curing speed has to be used in order to improve curability, there is a problem in that the mere addition of the curing agent for increasing curing speed causes a reduction in in-mold flowability (in particular, flowability in thin wall parts), a degradation in moldability, and a reduction in workability.

The present invention has been made in order to solve the above-mentioned problems. An object of the present invention is to provide an unsaturated polyester resin composition, which yields a cured product having a low molding shrinkage ratio, a low linear expansion coefficient, and a high thermal conductivity coefficient, and is excellent in in-mold flowability and curability.

Further, another object of the present invention is to provide an encapsulated motor, which can be manufactured with satisfactory workability and productivity, and is excellent in heat dissipation properties.

### Means for Solving the Problems

The inventors of the present invention have made intensive studies in order to solve the above-mentioned problems. As a result, the inventors have found that satisfactory in-mold flowability can be maintained while increasing curing speed by blending a specific curing agent and polymerization inhibitor into an unsaturated polyester resin composition having a predetermined composition, to thus complete the present invention.

That is, the present invention is an unsaturated polyester resin composition comprising 100 parts by mass of an unsaturated polyester resin (a); 400 to 1,000 parts by mass of a mixture of an inorganic filler (b) having a thermal conductivity coefficient of 20 W/m.K or more and aluminum hydroxide (c); 20 to 300 parts by mass of a glass fiber (d) having a fiber length of 1.5 mm or less; and 15 to 50 parts by mass of a low profile additive (e), the inorganic filler (b) and the aluminum hydroxide (c) being mixed at a mass ratio of 80:20 to 20:80, in which the unsaturated polyester resin composition further includes an alkyl peroxyalkylate-based curing agent (f) represented by the following formula (1) and a polymerization inhibitor (g).

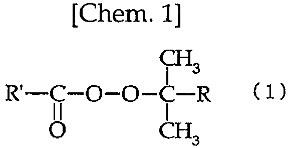

In the formula, R represents an alkyl group; and R' represents an alkyl group having 3 or more carbon atoms.

The present invention is also an encapsulated motor, which is produced by encapsulation molding of a motor component with the above-mentioned unsaturated polyester resin composition.

### Effects of the Invention

According to the present invention, it is possible to provide the unsaturated polyester resin composition, which yields a cured product having a low molding shrinkage ratio, a low linear expansion coefficient, and a high thermal conductivity coefficient, and is excellent in in-mold flowability and curability.

Further, according to the present invention, it is possible to provide an encapsulated motor, which can be manufactured with satisfactory workability and productivity, and is excellent in heat dissipation properties.

### Modes for Carrying Out the Invention

An unsaturated polyester resin composition of the present invention includes an unsaturated polyester resin (a), an inorganic filler (b), aluminum hydroxide (c), a glass fiber (d), a low profile additive (e), an alkyl peroxyalkylate-based curing agent (f), and a polymerization inhibitor (g). Hereinafter, the respective ingredients are described.

### Unsaturated polyester resin (a)

The unsaturated polyester resin (a) to be used in the present invention is not particularly limited, and those known as a molding material in the art may be used. In general, the unsaturated polyester resin (a) is a resin obtained by dissolving in a crosslinking agent a compound (unsaturated polyester) obtained by polycondensation (esterification) of a polyhydric alcohol and an unsaturated polybasic acid or a saturated polybasic acid. It should be noted that a vinyl ester resin may also be used as part of the unsaturated polyester resin (a).

The polyhydric alcohol to be used in the synthesis of the unsaturated polyester is not particularly limited, and known ones may be used. Examples of the polyhydric alcohol include ethylene glycol, propylene glycol, butanediol, diethylene glycol, dipropylene glycol, triethylene glycol, pentanediol, hexanediol, neopentanediol, hydrogenated bisphenol A, bisphenol A, and glycerin. Those polyhydric alcohols may be used alone or in combinations of two or more thereof.

The unsaturated polybasic acid to be used in the synthesis of the unsaturated polyester is not particularly limited, and known ones may be used. Examples of the unsaturated polybasic acid include maleic anhydride, fumaric acid, citraconic acid, and itaconic acid. They may be used alone or in combinations of two or more thereof.

The saturated polybasic acid to be used in the synthesis of the unsaturated polyester is not particularly limited, and known ones may be used. Examples of the saturated polybasic acid include phthalic anhydride, isophthalic acid, terephthalic acid, HET acid, succinic acid, adipic acid, sebacic acid, tetrachlorophthalic anhydride, tetrabromophthalic anhydride, and endomethylenetetrahydrophthalic anhydride. Those saturated polybasic acids may be used alone or in combinations of two or more thereof.

The unsaturated polyester may be synthesized by a known method using the above-mentioned raw materials. Various conditions in the synthesis need to be appropriately set depending on raw materials to be used and amounts thereof. In general, however, in a gas stream of inert gas such as nitrogen, an esterification reaction may be performed under pressure or under reduced pressure at a temperature of 140 to 230°C. In the esterification reaction, an esterification catalyst may be used as necessary. Examples of the catalyst include known catalysts such as manganese acetate, dibutyl tin oxide, stannous oxalate, zinc acetate, and cobalt acetate. Those catalysts may be used alone or in combinations of two or more thereof.

The crosslinking agent to be used for the unsaturated polyester resin (a) is not particularly limited as long as the crosslinking agent has a polymerizable double bond capable of polymerizing with the unsaturated polyester. Examples of the crosslinking agent include a styrene monomer, a diallyl phthalate monomer, a diallyl phthalate prepolymer, methyl methacrylate, and triallyl isocyanurate. Those crosslinking agents may be used alone or in combinations of two or more thereof.

The content of the crosslinking agent in the unsaturated polyester resin (a) is preferably 25 to 70 mass%, more preferably 35 to 65 mass%. When the content of the crosslinking agent is less than 25 mass%, the viscosity of the resin increases and workability may be deteriorated. On the other hand, when the content of the crosslinking agent is more than 70 mass%, a cured product having desired physical properties may not be obtained.

### Inorganic filler (b)

The inorganic filler (b) to be used in the present invention has a thermal conductivity coefficient of 20 W/m·K or more, preferably 30 W/m·K or more. From the viewpoint of thermal conductivity, the upper limit of the thermal conductivity coefficient of the inorganic filler (b) is not particularly limited and is generally 200 W/m·K. When the inorganic filler (b) has a thermal conductivity coefficient of less than 20 W/m·K, a cured product having the desired thermal conductivity coefficient cannot be obtained.

Examples of the inorganic filler (b) having a thermal conductivity coefficient within the above-mentioned range include aluminum oxide, magnesium oxide, beryllium oxide, aluminum nitride, boron nitride, titanium nitride, silicon carbide, boron carbide, titanium carbide, and titanium boride. Those inorganic fillers may be used alone or in combinations of two or more thereof.

Further, the inorganic filler (b) has an average particle diameter of preferably 0.5 to 30 µm, more preferably 1 to 10 µm from the viewpoint of being uniformly dispersed in the unsaturated polyester resin composition, and a particle shape thereof is desirably an amorphous shape or a spherical powder shape.

### Aluminum hydroxide (c)

The aluminum hydroxide (c) to be used in the present invention is not particularly limited, and known ones may be used. Further, the aluminum hydroxide (c) has an average particle diameter of preferably 0.5 to 100 µm, more preferably 5 to 30 µm from the viewpoint of being uniformly dispersed in the unsaturated polyester resin composition, and the particle shape thereof is desirably an amorphous shape or a spherical powder shape.

The blending amount of the inorganic filler (b) and the aluminum hydroxide (c), i.e., the total amount of the inorganic filler (b) and the aluminum hydroxide (c) in the unsaturated polyester resin composition of the present invention is 400 to 1,000 parts by mass, preferably 500 to 900 parts by mass with respect to 100 parts by mass of the unsaturated polyester resin (a). When the total amount of the inorganic filler (b) and the aluminum hydroxide (c) is less than 400 parts by mass, the thermal conductivity coefficient of a cured product is lowered and desired heat dissipation properties cannot be obtained. On the other hand, when the total amount is more than 1,000 parts by mass, the viscosity of the unsaturated polyester resin composition increases, with the result that the in-mold flowability remarkably lowers and it becomes difficult to mix the respective ingredients in the manufacture of the unsaturated polyester resin composition.

The mass ratio of the inorganic filler (b) to the aluminum hydroxide (c) in the unsaturated polyester resin composition of the present invention is 80:20 to 20:80, preferably 70:30 to 30:70. When the mass ratio of the inorganic filler (b) to the aluminum hydroxide (c) is outside the above-mentioned range, the in-mold flowability of the unsaturated polyester resin composition is remarkably lowered and it becomes difficult to mix the respective ingredients in the manufacture of the unsaturated polyester resin composition.

It should be noted that, when a filler (for example, calcium carbonate, barium sulfate, talc, or silica) excluding the above-mentioned inorganic filler (b) and aluminum hydroxide (c) is used in place of the inorganic filler (b) and the aluminum hydroxide (c), a cured product having the desired thermal conductivity coefficient and in-mold flowability cannot be obtained. However, a filler excluding the inorganic filler (b) and the aluminum hydroxide (c) may be blended together with the inorganic filler (b) and the aluminum hydroxide (c) in such a range that the effects of the present invention are not impaired. In this case, the blending amount of the filler excluding the inorganic filler (b) and the aluminum hydroxide (c) is preferably 80 parts by mass or less with respect to 100 parts by mass of the aluminum hydroxide (c).

### Glass fiber (d)

The glass fiber (d) to be used in the present invention needs to be a short fiber and have a fiber length of 1.5 mm or less, preferably 100 to 500 µm. When the fiber length is more than 1.5 mm, the in-mold flowability of the unsaturated polyester resin composition is remarkably lowered.

The blending amount of the glass fiber (d) in the unsaturated polyester resin composition of the present invention is 20 to 300 parts by mass, preferably 50 to 250 parts by mass with respect to 100 parts by mass of the unsaturated polyester resin (a). When the blending amount of the glass fiber (d) is less than 20 parts by mass, the linear expansion coefficient of a cured product becomes high. On the other hand, when the blending amount of the glass fiber (d) is more than 300 parts by mass, the in-mold flowability of the unsaturated polyester resin composition is remarkably lowered.

### Low profile additive (e)

The low profile additive (e) to be used in the present invention is not particularly limited, and known ones may be used. Examples of the low profile additive (e) include thermoplastic polymers generally used as low profile additives, such as polystyrene, polymethyl methacrylate, polyvinyl acetate, saturated polyesters, and styrene-butadiene-based rubber. Those low profile additives may be used alone or in combinations of two or more thereof. Further, polystyrene is preferably used as the low profile additive (e) from the viewpoint of reducing shrinkage.

The blending amount of the low profile additive (e) in the unsaturated polyester resin composition of the present invention is 15 to 50 parts by mass with respect to 100 parts by mass of the unsaturated polyester resin (a). When the blending amount of the low profile additive (e) is less than 15 parts by mass, the molding shrinkage ratio of a cured product becomes high. On the other hand, when the blending amount of the low profile additive (e) is more than 50 parts by mass, the in-mold flowability of the unsaturated polyester resin composition is remarkably lowered.

### Alkyl peroxyalkylate-based curing agent (f)

The alkyl peroxyalkylate-based curing agent (f) to be used in the present invention is represented by the following formula (1).

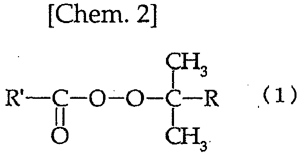

In the above-mentioned formula (1), R represents an alkyl group; and R' represents an alkyl group having 3 or more carbon atoms. When the number of carbon atoms in R' is less than 3, desired curing speed may not be obtained.

R preferably represents a linear or branched alkyl group having 1 to 5 carbon atoms. Examples of R include a methyl group, an ethyl group, and a butyl group. Examples of the branched alkyl group include a 2,2-dimethylpropyl group. R' preferably represents a linear or branched alkyl group having 3 to 9 carbon atoms. Examples of R' include a butyl group. Examples of the branched alkyl group include a 2,2-dimethylpropyl group and a 1-ethylpentyl group.

Specific examples of the alkyl peroxyalkylate-based curing agent (f) represented by the above-mentioned formula (1) include 1,1,3,3-tetramethylbutyl peroxyneodecanoate, t-hexyl peroxyneodecanoate, t-butyl peroxyneodecanoate, t-butyl peroxyneoheptanoate, t-butyl peroxypivalate, t-hexyl peroxypivalate, t-butyl peroxy-2-ethylhexanoate, 1,1,3,3-tetramethylbutyl peroxy-2-ethylhexanoate, t-hexyl peroxy-2-ethylhexanoate, and t-amyl peroxy-2-ethylhexanoate. These alkyl peroxyalkylate-based curing agents may be used alone or in combinations of two or more thereof.

The alkyl peroxyalkylate-based curing agent (f) preferably has a 10-hour half-life temperature of 80°C or less. Here, the 10-hour half-life temperature means a decomposition temperature at which the concentration of an organic peroxide is halved in 10 hours when subjecting a 0.1 mol/L solution of the organic peroxide in cumene to thermal decomposition. When the alkyl peroxyalkylate-based curing agent (f) has a 10-hour half-life temperature of more than 80°C, desired curing speed may not be obtained because the thermal decomposition temperature is too high.

The blending amount of the alkyl peroxyalkylate-based curing agent (f) in the unsaturated polyester resin composition of the present invention is preferably 0.1 to 8 parts by mass, more preferably 2 to 6 parts by mass with respect to 100 parts by mass of the unsaturated polyester resin (a). When the blending amount of the alkyl peroxyalkylate-based curing agent (f) is less than 0.1 part by mass, a curing time may be prolonged or curing may be insufficient. On the other hand, when the blending amount of the alkyl peroxyalkylate-based curing agent (f) is more than 8 parts by mass, an effect based on an increased amount of the alkyl peroxyalkylate-based curing agent (f) cannot be exhibited, and a large amount of the alkyl peroxyalkylate-based curing agent (f) may be wasted.

### Polymerization inhibitor (g)

The polymerization inhibitor (g) to be used in the present invention is not particularly limited, and known ones may be used. Examples of the polymerization inhibitor (g) include quinones such as p-benzoquinone, toluquinone, naphthoquinone, phenanthraquinone, and 2,5-diphenyl-p-benzoquinone; hydroquinones such as toluhydroquinone, hydroquinone, tert-butylcatechol, mono-tert-butylhydroquinone, and 2,5-di-tert-butylhydroquinone; and monophenols such as hydroquinone monomethyl ether and 2,6-di-t-butyl-p-cresol. Those polymerization inhibitors may be used alone or in combinations of two or more thereof. Further, among them, quinones are preferably used from the viewpoint of suppressing gelation.

The blending amount of the polymerization inhibitor (g) in the unsaturated polyester resin composition of the present invention is preferably 0.005 to 0.2 part by mass, more preferably 0.01 to 0.1 part by mass with respect to 100 parts by mass of the unsaturated polyester resin (a). When the blending amount of the polymerization inhibitor (g) is less than 0.005 part by mass, an unsaturated polyester resin composition having desired in-mold flowability may not be obtained. On the other hand, when the blending amount of the polymerization inhibitor (g) is more than 0.2 part by mass, curing time may be prolonged or curing may be insufficient.

The unsaturated polyester resin composition of the present invention may include optional ingredients such as a mold release agent, a thickener, and a pigment, as necessary, from the viewpoint of improving various physical properties.

The kinds of mold release agent, thickener, and pigment are not particularly limited, and known ones may be used. Examples of the mold release agent include stearic acid, zinc stearate, calcium stearate, aluminum stearate, magnesium stearate, and carnauba wax. Examples of the thickener include metal oxides such as magnesium oxide, magnesium hydroxide, calcium hydroxide, and calcium oxide, and isocyanate compounds. Those ingredients may be used alone or in combinations of two or more thereof.

It should be noted that the blending amount of each of the above-mentioned optional ingredients is not particularly limited as long as the effects of the present invention are not impaired.

The unsaturated polyester resin composition of the present invention may be manufactured by blending and kneading the above-mentioned ingredients in predetermined amounts by a conventional method. For example, the unsaturated polyester resin composition may be obtained by loading and mixing the respective ingredients in predetermined amounts in a kneader or the like.

The unsaturated polyester resin composition of the present invention is excellent in both in-mold flowability and curability, and hence can improve workability and productivity in the manufacture of a cured product having a desired shape.

Further, the unsaturated polyester resin composition of the present invention yields a cured product having a low molding shrinkage ratio, a low linear expansion coefficient, and a high thermal conductivity coefficient, and hence may be used as an encapsulating material for electrical and electronic parts such as motors and coils. In particular, the unsaturated polyester resin composition of the present invention yields a cured product having a high thermal conductivity coefficient, and hence is optimal for an encapsulating material for motors requiring a high degree of heat dissipation properties.

An encapsulated motor, which is produced by encapsulation molding of a motor component with the unsaturated polyester resin composition of the present invention, is excellent in heat dissipation properties and can be manufactured with satisfactory workability and productivity.

Here, a method for the encapsulation molding is not particularly limited, and the encapsulation molding may be performed by conventional methods. For example, compression molding, transfer molding, injection molding, and the like may be employed.

### Examples

Hereinafter, the present invention is described in detail by way of examples and comparative examples. However, the present invention is by no means limited by these examples and comparative examples.

Various physical properties in unsaturated polyester resin compositions and cured products thereof according to the following examples and comparative examples were evaluated as described below.

### (1) Molding shrinkage ratio

A shrinkage disk defined in JIS K6911 was subjected to compression molding at a molding temperature of 150°C under a molding pressure of 10 MPa for a molding time of 3 minutes to calculate a molding shrinkage ratio based on JIS K6911. Here, an encapsulated motor or the like is used under a harsh environment, and hence the molding shrinkage ratio in this evaluation must fall within the range of -0.05% to 0.05% from the viewpoint of preventing the occurrence of cracks due to thermal expansion or shrinkage.

### (2) Thermal conductivity coefficient

A flat plate measuring 150x150x20 (in thickness) mm was molded by compression molding at a molding temperature of 150°C under a molding pressure of 10 MPa for a molding time of 3 minutes, and measured for its thermal conductivity coefficient by a QTM method (measuring machine: QTM-DII manufactured by Showa Denko K.K.). Here, an encapsulated motor or the like requires a high degree of heat dissipation properties, and hence the thermal conductivity coefficient in this evaluation must be 1.0 W/m·K or more.

### (3) Linear expansion coefficient

A flat plate measuring 90x10x4 (in thickness) mm was molded by compression molding at a molding temperature of 150°C under a molding pressure of 10 MPa for a molding time of 3 minutes, cut into test pieces measuring 20x4x4 mm, and measured for its linear expansion coefficient by a TMA method (measuring machine: TMA8310 manufactured by Rigaku Corporation). Here, an encapsulated motor or the like is used under a harsh environment, and hence the linear expansion coefficient in this evaluation must be 1.5×10⁻⁵/°C or less from the viewpoint of preventing the occurrence of cracks due to thermal expansion or shrinkage.

### (4) In-mold flowability

In conformity with an ASTM method, a spiral flow test was performed using a semicircular spiral flow mold having a cross-section shape with a diameter of 3 mm under the conditions of a mold temperature of 150°C, an injection pressure of 10 MPa, an injection time of 30 seconds, a curing time of 90 seconds, and a thickness of a molded product of 3 mm, to thereby measure flow length. In this test, a case where the flow length was 55 mm or more is expressed as "⊚" (very satisfactory), a case where the flow length was 45 mm or more and less than 55 mm is expressed as "○" (satisfactory), a case where the flow length was 35 mm or more and less than 45 mm is expressed as "Δ" (slightly poor), a case where the flow length is 25 mm or more and less than 35 mm is expressed as " × " (poor), and a case where the flow length was less than 25 mm is expressed as "××" " (not flowing, unable to be manufactured).

Further, a spiral flow test was performed in the same manner as described above except that the thickness of the molded product was changed to 100 µm. In this test, a case where the flow length was 45 mm or more is expressed as "⊚" (very satisfactory), a case where the flow length was 35 mm or more and less than 45 mm is expressed as "○" (satisfactory), a case where the flow length was 25 mm or more and less than 35 mm is expressed as "Δ" (slightly poor), a case where the flow length was 15 mm or more and less than 25 mm is expressed as "×" (poor), and a case where the flow length was less than 15 mm is expressed as "××" (not flowing, unable to be manufactured).

### (5) Curability

A curing test was performed using a curelastometer (WP-type manufactured by JSR Trading Co., Ltd.) to measure a change in torque in a curing process. Then, the time to achieve 10% of the maximum torque (hereinafter, referred to as tc10) and the time to achieve 90% of the maximum torque (hereinafter, referred to as tc90) were evaluated. It should be noted that tc10 serves as an indicator of a gelation time, tc90 serves as an indicator of a mold release time, and tc90-tc10 serves as an indicator of a rise time in curing.

### (6) Kneadability

In the evaluation of kneadability, a case where the respective ingredients were kneadable in kneading the ingredients using a dual arm kneader is expressed as "○" and a case where the respective ingredients were not kneadable in kneading the ingredients using a dual arm kneader is expressed as "×".

### (Examples 1 to 13)

A four-necked flask equipped with a temperature gauge, a stirrer, an inert gas inlet, and a reflux condenser was loaded with 100 mol of fumaric acid, 80 mol of propylene glycol, and 20 mol of hydrogenated bisphenol A. Then, the mixture was heated to a temperature of 200°C with stirring under a nitrogen gas stream, and subjected to an esterification reaction in accordance with a conventional procedure to obtain an unsaturated polyester. The unsaturated polyester was dissolved in a styrene monomer (crosslinking agent) to obtain an unsaturated polyester resin. Here, the content of the styrene monomer in the unsaturated polyester resin was set to 40 mass%.

With use of the unsaturated polyester resin, the respective ingredients were kneaded according to the blending compositions shown in Table 1 and Table 2 using a dual arm kneader to obtain unsaturated polyester resin compositions. It should be noted that t-butyl peroxy-2-ethylhexanoate as an alkyl peroxyalkylate-based curing agent has a 10-hour half-life temperature of 72°C and 1,1,3,3-tetramethylbutyl peroxy-2-ethylhexanoate has a 10-hour half-life temperature of 65.3°C. Further, alumina has a thermal conductivity coefficient of 36 W/m·K and aluminum nitride has a thermal conductivity coefficient of 200 W/m·K.

The resultant unsaturated polyester resin compositions and cured products thereof were evaluated for the above-mentioned physical properties. Tables 1 and 2 show the results.

### (Comparative Examples 1 to 12)

With use of the unsaturated polyester resins used in Examples 1 to 13, the respective ingredients were kneaded according to the blending compositions shown in Table 3 and Table 4 using a dual arm kneader to obtain unsaturated polyester resin compositions. The resultant unsaturated polyester resin compositions and cured products thereof were evaluated for the above-mentioned physical properties. Tables 3 and 4 show the results.

**[Table 1]**

| Ingredients | | Example 1 | Example 2 | Example 3 | Example 4 | Example 5 | Example 6 |
|---|---|---|---|---|---|---|---|
| (a) Unsaturated polyester resin | | 100 | 100 | 100 | 100 | 100 | 100 |
| (b) Alumina (average particle diameter: 2 µm) | | 350 | 450 | 200 | 560 | 140 | 350 |
| (c) Aluminum hydroxide (average particle diameter: 8 µm) | | 350 | 450 | 200 | 140 | 560 | 350 |
| (d) Chopped glass (1.5 mm) | | 150 | 150 | 150 | 150 | 150 | 20 |
| (e) Polystyrene | | 30 | 30 | 30 | 30 | 30 | 30 |
| (f) t-Butyl peroxy-2-ethylhexanoate | | 5 | 5 | 5 | 5 | 5 | 5 |
| (g) p-Benzoquinone | | 0.05 | 0.05 | 0.05 | 0.05 | 0.05 | 0.05 |
| Zinc stearate | | 8 | 8 | 8 | 8 | 8 | 8 |
| (b):(c) | | 50:50 | 50:50 | 50:50 | 80:20 | 20:80 | 50:50 |
| Number of parts by mass of (b)+(c) with respect to 100 parts by mass of (a) | | 700 | 1,000 | 400 | 700 | 700 | 700 |
| Curability | tc10 (min.) | 0.28 | 0.30 | 0.25 | 0.28 | 0.28 | 0.26 |
| | tc90 (min.) | 0.56 | 0.58 | 0.54 | 0.57 | 0.58 | 0.56 |
| | tc90-tc10 (min.) | 0.28 | 0.28 | 0.29 | 0.29 | 0.30 | 0.30 |
| Molding shrinkage ratio (%) | | 0.02 | 0.01 | 0.03 | 0.02 | 0.03 | 0.04 |
| Thermal conductivity coefficient (W/m·K) | | 1.3 | 1.6 | 1.2 | 1.5 | 1.2 | 1.3 |
| Linear expansion coefficient (×10⁻⁵/°C) | | 1.2 | 1.4 | 1.3 | 1.2 | 1.3 | 1.5 |
| In-mold flowability | thickness: 3 mm | ⊚ | ○ | ⊚ | ⊚ | ○ | ⊚ |
| | thickness:100 µm | ⊚ | ○ | ⊚ | ⊚ | ○ | ⊚ |
| Kneadability | | ○ | ○ | ○ | ○ | ○ | ○ |

**[Table 2]**

| Ingredients | | Example 7 | Example 8 | Example 9 | Example 10 | Example 11 | Example 12 | Example 13 |
|---|---|---|---|---|---|---|---|---|
| (a) Unsaturated polyester resin | | 100 | 100 | 100 | 100 | 100 | 100 | 100 |
| (b) Alumina (average particle diameter: 2 µm) | | 250 | 350 | 350 | 350 | - | 350 | 350 |
| (b) Aluminum nitride (average particle diameter: 2 µm) | | - | - | - | - | 350 | - | - |
| (c) Aluminum hydroxide (average particle diameter: 8 µm) | | 250 | 350 | 350 | 350 | 350 | 350 | 350 |
| (d) Chopped glass (1.5 mm) | | 300 | 150 | 150 | 150 | 150 | 150 | 150 |
| (e) Polystyrene | | 30 | 15 | 50 | - | 30 | 30 | 30 |
| (e) Polymethyl methacrylate | | - | - | - | 30 | - | - | - |
| (f) t-Butyl peroxy-2-ethylhexanoate | | 5 | 5 | 5 | 5 | 5 | - | 5 |
| (f) 1,1,3,3-Tetramethylbutyl peroxy-2-ethylhexanoate | | - | - | - | - | - | 5 | - |
| (g) p-Benzoquinone | | 0.05 | 0.05 | 0.05 | 0.05 | 0.05 | 0.05 | - |
| (g) Hydroquinone | | - | - | - | - | - | - | 0.05 |
| Zinc stearate | | 8 | 8 | 8 | 8 | 8 | 8 | 8 |
| (b):(c) | | 50:50 | 50:50 | 50:50 | 50:50 | 50:50 | 50:50 | 50:50 |
| Number of parts by mass of (b)+(c) with respect to 100 parts by mass of (a) | | 700 | 700 | 700 | 700 | 700 | 700 | 700 |
| Curability | tc10 (min.) | 0.28 | 0.29 | 0.26 | 0.28 | 0.28 | 0.25 | 0.26 |
| | tc90 (min.) | 0.56 | 0.58 | 0.55 | 0.56 | 0.58 | 0.50 | 0.55 |
| | tc90-tc10 (min.) | 0.28 | 0.29 | 0.29 | 0.28 | 0.30 | 0.25 | 0.29 |
| Molding shrinkage ratio (%) | | 0.02 | 0.05 | 0.00 | 0.03 | 0.02 | 0.00 | 0.02 |
| Thermal conductivity coefficient (W/m·K) | | 1.1 | 1.3 | 1.3 | 1.3 | 1.6 | 1.2 | 1.2 |
| Linear expansion coefficient (×10⁻⁵/°C) | | 1.1 | 1.3 | 1.1 | 1.2 | 1.2 | 1.2 | 1.2 |
| In-mold flowability | thickness: 3 mm | ○ | ⊚ | ○ | ⊚ | ⊚ | ○ | ○ |
| | thickness: 100 µm | ○ | ⊚ | ○ | ⊚ | ⊚ | ○ | ○ |
| Kneadability | | ○ | ○ | ○ | ○ | ○ | ○ | ○ |

**[Table 3]**

| Ingredients | | Comparative Example 1 | Comparative Example 2 | Comparative Example 3 | Comparative Example 4 | Comparative Example 5 | Comparative Example 6 |
|---|---|---|---|---|---|---|---|
| (a) Unsaturated polyester resin | | 100 | 100 | 100 | 100 | 100 | 100 |
| (b) Alumina (average particle diameter: 2 µm) | | 350 | 350 | 600 | 100 | 630 | 70 |
| (c) Aluminum hydroxide (average particle diameter: 8 µ m) | | 350 | 350 | 600 | 100 | 70 | 630 |
| (d) Chopped glass (1.5 mm) | | 150 | 150 | 150 | 150 | 150 | 150 |
| (e) Polystyrene | | 30 | 30 | 30 | 30 | 30 | 30 |
| (f) t-Butyl peroxy-2-ethylhexanoate | | - | 5 | 5 | 5 | 5 | 5 |
| t-Butyl peroxybenzoate | | 5 | - | - | - | - | - |
| (g) p-Benzoquinone | | - | - | 0.05 | 0.05 | 0.05 | 0.05 |
| Zinc stearate | | 8 | 8 | 8 | 8 | 8 | 8 |
| (b):(c) | | 50:50 | 50:50 | 50:50 | 50:50 | 90:10 | 10:90 |
| Number of parts by mass of (b)+(c) with respect to 100 parts by mass of (a) | | 700 | 700 | 1,200 | 200 | 700 | 700 |
| Curability | tc10 (min.) | 0.35 | 0.21 | - | 0.25 | 0.28 | 0.28 |
| | tc90 (min.) | 1.10 | 0.50 | - | 0.52 | 0.57 | 0.58 |
| | tc90-tc10 (min.) | 0.75 | 0.29 | - | 0.27 | 0.29 | 0.30 |
| Molding shrinkage ratio (%) | | 0.05 | -0.01 | - | 0.07 | 0.03 | 0.03 |
| Thermal conductivity coefficient (W/m·K) | | 1.3 | 1.3 | - | 0.8 | 1.5 | 1.0 |
| Linear expansion coefficient (×10⁻⁵/°C) | | 1.2 | 1.2 | - | 1.4 | 1.3 | 1.3 |
| In-mold flowability | thickness: 3 mm | ⊚ | Δ | - | ⊚ | Δ | × |
| | thickness:100 µm | ⊚ | Δ | - | ⊚ | Δ | × |
| Kneadability | | ○ | ○ | × | ○ | ○ | ○ |

**[Table 4]**

| Ingredients | | Comparative Example 7 | Comparative Example 8 | Comparative Example 9 | Comparative Example 10 | Comparative Example 11 | Comparative Example 12 |
|---|---|---|---|---|---|---|---|
| (a) Unsaturated polyester resin | | 100 | 100 | 100 | 100 | 100 | 100 |
| (b) Alumina (average particle diameter: 2 µm) | | - | 350 | 350 | 350 | 350 | 350 |
| Calcium carbonate (average particle diameter: 2 µm) | | 350 | - | - | - | - | - |
| (c) Aluminum hydroxide (average particle diameter: 8 µ m) | | 350 | 350 | 350 | 350 | 350 | 350 |
| (d) Chopped glass (1.5 mm) | | 150 | 10 | 400 | 150 | 150 | 150 |
| (e) Polystyrene | | 30 | 30 | 30 | 12 | 60 | 30 |
| (f) t-Butyl peroxy-2-ethylhexanoate | | 5 | 5 | 5 | 5 | 5 | - |
| t-Butyl peroxyacetate | | - | - | - | - | - | 5 |
| (g) p-Benzoquinone | | 0.05 | 0.05 | 0.05 | 0.05 | 0.05 | - |
| Zinc stearate | | 8 | 8 | 8 | 8 | 8 | 8 |
| (b):(c) | | - | 50:50 | 50:50 | 50:50 | 50:50 | 50:50 |
| Number of parts by mass of (b)+(c) with respect to 100 parts by mass of (a) | | - | 700 | 700 | 700 | 700 | 700 |
| Curability | tc10 (min.) | 0.29 | 0.26 | 0.30 | 0.27 | 0.28 | 0.39 |
| | tc90 (min.) | 0.59 | 0.56 | 0.61 | 0.57 | 0.58 | 0.83 |
| | tc90-tc10 (min.) | 0.30 | 0.30 | 0.31 | 0.30 | 0.30 | 0.44 |
| Molding shrinkage ratio (%) | | 0.03 | 0.03 | 0.00 | 0.08 | -0.01 | 0.03 |
| Thermal conductivity coefficient (W/m·K) | | 1.0 | 1.3 | 1.3 | 1.3 | 1.3 | 1.3 |
| Linear expansion coefficient (×10⁻⁵/°C) | | 1.2 | 1.8 | 1.1 | 1.3 | 1.3 | 1.3 |
| In-mold flowability | thickness: 3 mm | × | ⊚ | ×× | ⊚ | Δ | ⊚ |
| | thickness: 100 µm | × | ⊚ | ×× | ⊚ | Δ | ⊚ |
| Kneadability | | ○ | ○ | ○ | ○ | ○ | ○ |

As shown in the results of Tables 1 and 2, the unsaturated polyester resin compositions of Examples 1 to 13 each showed a long gelation time (tc10) and excellent in-mold flowability, which gave high moldability and excellent workability. Further, the unsaturated polyester resin compositions of Examples 1 to 13 each showed a short rise time in curing (tc90-tc10), a short mold releasable time (tc90), and high curing speed, which gave excellent productivity. In addition, the cured products obtained from the unsaturated polyester resin compositions of Examples 1 to 13 were excellent in all of the thermal conductivity coefficient, the molding shrinkage ratio, and the linear expansion coefficient.

On the other hand, as shown in the results of Tables 3 and 4, the unsaturated polyester resin composition free of a predetermined alkyl peroxyalkylate-based curing agent and polymerization inhibitor (Comparative Example 1) showed a long rise time in curing, a long mold release time, and low curing speed, which did not give sufficient productivity. Further, the unsaturated polyester resin composition free of a polymerization inhibitor only (Comparative Example 2) showed high curing speed but showed poor flowability, which did not give sufficient workability. The unsaturated polyester resin compositions (Comparative Examples 3 to 6 and 8 to 11) in each of which the contents of the respective ingredients and the like are outside a predetermined range and the unsaturated polyester resin composition using an inorganic filler having no thermal conductivity coefficient within a predetermined range (Comparative Example 7) were not kneadable, or were insufficient in any of the thermal conductivity coefficient, the molding shrinkage ratio, or the linear expansion coefficient of a cured product. In addition, the unsaturated polyester resin composition using an alkyl peroxyalkylate-based curing agent (t-hexyl peroxyacetate) in which R' in the formula (1) was less than 3 (Comparative Example 12) showed a low curing speed.

As seen from the above-mentioned results, according to the present invention, it is possible to provide the unsaturated polyester resin composition, which yields a cured product having a low molding shrinkage ratio, a low linear expansion coefficient, and a high thermal conductivity coefficient, and is excellent in in-mold flowability and curability. Further, according to the present invention, it is possible to provide an encapsulated motor, which can be manufactured with satisfactory workability and productivity, and is excellent in heat dissipation properties.

It should be noted that this international application claims priority based on Japanese Patent Application No. 2009-149792 filed on June 24, 2009, and the content of Japanese Patent Application No. 2009-149792 is incorporated into this international application in its entirety.

## Claims

1. An unsaturated polyester resin composition comprising 100 parts by mass of an unsaturated polyester resin (a); 400 to 1,000 parts by mass of a mixture of an inorganic filler (b) having a thermal conductivity coefficient of 20 W/m·K or more and aluminum hydroxide (c); 20 to 300 parts by mass of a glass fiber (d) having a fiber length of 1.5 mm or less; and 15 to 50 parts by mass of a low profile additive (e), the inorganic filler (b) and the aluminum hydroxide (c) being mixed at a mass ratio of 80:20 to 20:80, wherein the unsaturated polyester resin composition further comprises an alkyl peroxyalkylate-based curing agent (f) represented by the following formula (1): 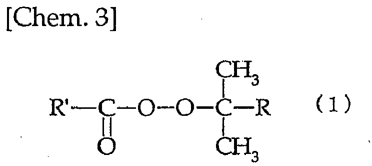 wherein R represents an alkyl group; and R' represents an alkyl group having 3 or more carbon atoms, and a polymerization inhibitor (g).

2. An unsaturated polyester resin composition according to claim 1, wherein the alkyl peroxyalkylate-based curing agent (f) has a 10-hour half-life temperature of 80°C or less.

3. An unsaturated polyester resin composition according to claim 1 or 2, wherein the alkyl peroxyalkylate-based curing agent (f) is one or more kinds selected from the group consisting of 1,1,3,3-tetramethylbutyl peroxyneodecanoate, t-hexyl peroxyneodecanoate, t-butyl peroxyneodecanoate, t-butyl peroxyneoheptanoate, t-hexyl peroxypivalate, t-butyl peroxy-2-ethylhexanoate, 1,1,3,3-tetramethylbutyl peroxy-2-ethylhexanoate, t-hexyl peroxy-2-ethylhexanoate, t-amyl peroxy-2-ethylhexanoate, and t-butyl peroxypivalate.

4. An unsaturated polyester resin composition according to any one of claims 1 to 3, wherein the polymerization inhibitor (g) is one or more kinds selected from the group consisting of quinones, hydroquinones, and monophenols.

5. An encapsulated motor, which is produced by encapsulation molding of a motor component with the unsaturated polyester resin composition according to any one of claims 1 to 4.

## Patentansprüche

1. Ungesättigte Polyesterharzzusammensetzung, die 100 Masseteile eines ungesättigten Polyesterharzes (a); 400 bis 1000 Masseteile einer Mischung aus einem anorganischen Füllstoff (b) mit einem thermischen Leitfähigkeitskoeffizienten von 20 W/m.k oder mehr und Aluminiumhydroxid (c); 20 bis 300 Masseteile einer Glasfaser (d) mit einer Faserlänge von 1,5 mm oder weniger; und 15 bis 50 Masseteile eines Low profile-Additivs (e) umfasst, wobei der anorganische Füllstoff (b) und das Aluminiumhydroxid (d) in einem Masseverhältnis von 80:20 bis 20:80 gemischt sind, wobei die ungesättigte Polyesterharzzusammensetzung ferner ein durch die folgende Formel (1) dargestelltes Alkylperoxyalkylat-basiertes Härtungsagens (f): 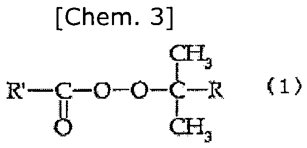 wobei R eine Alkylgruppe darstellt; und R' eine Alkylgruppe mit 3 oder mehr Kohlenstoffatomen darstellt, und einen Polymerisationsinhibitor (g) umfasst.

2. Ungesättigte Polyesterharzzusammensetzung nach Anspruch 1, wobei das Alkylperoxyalkylat-basierte Härtungsagens (f) eine 10-Stunden-Halbwertstemperatur von 80°C oder weniger aufweist.

3. Ungesättigte Polyesterharzzusammensetzung nach Anspruch 1 oder 2, wobei das Alkylperoxyalkylat-basierte Härtungsagens (f) eines oder mehrere Arten ist, die aus der Gruppe ausgewählt sind, die aus 1,1,3,3-Tetramethylbutylperoxyneodecanoat, t-Hexylperoxyneodecanoat, t-Butylperoxyneodecanoat, t-Butylperoxyneoheptanoat, t-Hexylperoxypivalat, t-Butylperoxy-2-ethylhexanoat, 1,1,3,3-Tetramethylbutylperoxy-2-ethylhexanoat, t-Hexylperoxy-2-ethylhexanoat, t-Amylperoxy-2-ethylhexanoat und t-Butylperoxypivalat besteht.

4. Ungesättigte Polyesterharzzusammensetzung nach einem der Ansprüche 1 bis 3, wobei der Polymerisationsinhibitor (g) einer oder mehrere Arten ist, die aus der Gruppe ausgewählt sind, die aus Chinonen, Hydrochinonen und Monophenolen besteht.

5. Eingekapselter Motor, welcher durch Einkapselungseingießen einer Motorkomponente mit der ungesättigten Polyesterharzzusammensetzung nach einem der Ansprüche 1 bis 4 hergestellt ist.

## Revendications

1. Composition de résine de polyester insaturée comprenant 100 parties en poids d'une résine de polyester insaturée (a) ; de 400 à 1000 parties en poids d'un mélange d'une charge inorganique (b) ayant un coefficient de conductivité thermique de 20 W/m·K ou plus et d'hydroxyde d'aluminium (c) ; de 20 à 300 parties en poids d'une fibre de verre (d) ayant une longueur de fibre de 1,5 mm ou moins ; et de 15 à 50 parties en poids d'un additif de bas profil (e), la charge inorganique (b) et l'hydroxyde d'aluminium (c) étant mélangés selon un rapport pondéral de 80:20 à 20:80, la composition de résine de polyester insaturée comprenant en outre un agent de durcissement à base de peroxyalkylate d'alkyle (f) représenté par la formule (1) suivante : 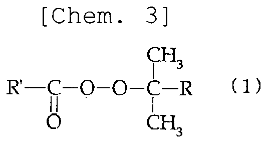 dans laquelle R représente un groupe alkyle ; et R' représente un groupe alkyle ayant 3 atomes de carbone ou plus, et un inhibiteur de polymérisation (g).

2. Composition de résine de polyester insaturée selon la revendication 1, dans laquelle l'agent de durcissement à base de peroxyalkylate d'alkyle (f) a une température de demi-vie de 10 heures de 80 °C ou moins.

3. Composition de résine de polyester insaturée selon la revendication 1 ou 2, dans laquelle l'agent de durcissement à base de peroxyalkylate d'alkyle (f) est un ou plusieurs types choisis dans le groupe constitué par le peroxynéodécanoate de 1,1,3,3-tétraméthylbutyle, le peroxynéodécanoate de t-hexyle, le peroxynéodécanoate de t-butyle, le peroxynéoheptanoate de t-butyle, le peroxypivalate de t-hexyle, le peroxy-2-éthylhexanoate de t-butyle, le peroxy-2-éthylhexanoate de 1,1,3,3-tétraméthylbutyle, le peroxy-2-éthylhexanoate de t-hexyle, le peroxy-2-éthylhexanoate de t-amyle et le peroxypivalate de t-butyle.

4. Composition de résine de polyester insaturée selon l'une quelconque des revendications 1 à 3, dans laquelle l'inhibiteur de polymérisation (g) est un ou plusieurs types choisis dans le groupe constitué par les quinones, les hydroquinones et les monophénols.

5. Moteur encapsulé, qui est produit par moulage par encapsulation d'un composant de moteur avec la composition de résine de polyester insaturée selon l'une quelconque des revendications 1 à 4.
